# EUROPEAN PATENT SPECIFICATION

(11) **EP 0 814 514 B1**
(45) Date of publication and mention of the grant of the patent: **14.08.2002**
(21) Application number: 97304161.9
(22) Date of filing: 13.06.1997
(51) Int. Cl.: H01L 27/108, H01L 21/8242, H01L 29/92, H01L 27/115, H01L 21/3205

(54) **A semiconductor memory device including a capacitor**
Halbleiterspeicherbauteil mit Kondensator
Dispositif semi-conducteur à mémoire ayant un condensateur

(30) Priority: 17.06.1996 KR 9621856
(43) Date of publication of application: 29.12.1997
(73) Proprietor: SAMSUNG ELECTRONICS CO., LTD., Suwon-City, Kyungki-do (KR)
(72) Inventor: Kang, Chang-seok, Suwon-city, Kyungki-do (KR)
(74) Representative: Ertl, Nicholas Justin

(56) References cited:
- EP-A- 0 490 240
- EP-A- 0 697 720
- US-A- 5 475 248
- PATENT ABSTRACTS OF JAPAN vol. 017, no. 276 (E-1372), 27 May 1993 & JP 05 013676 A (TOSHIBA CORP), 22 January 1993,

## Description

The present invention relates to a memory device and a manufacturing method thereof, and more particularly, to a capacitor of a semiconductor memory device comprised of a ferroelectric material as a dielectric film, and a manufacturing method thereof.

In general, in semiconductor memory devices, such as dynamic random access memories (DRAMs), as integration increases, the unit cell area decreases. When cell capacitance is reduced due to the reduction in the area of the memory cell, readout of the memory cell is deteriorated and the soft error ratio increases. Also, excessive amounts of power is required for device operation at low voltage. Accordingly, it is necessary to ensure a large enough cell capacitance so as not to deteriorate the operation characteristics of the memory cell.

Various methods for increasing capacitance of the memory cell within a defined cell area have been proposed, of which most fall into one of three methods. That is, a first method is to form a thinner dielectric film, a second method is to increase the effective area of the capacitor, and a third method is to use material having a high dielectric constant as the dielectric film. By the first method of forming a dielectric film having a thickness of 100Å or less, reliability of the device is deteriorated by the generation of a Fowler-Nordheim current. Thus, it is difficult to apply the method to a memory device having a large capacity. By the second method of forming a three-dimensional structure of the capacitor, a complicated process is required. Thus, a rise in the production cost is inevitable.

Accordingly, the third method, by which a dielectric film is formed using a dielectric material (hereinafter referred to as ferroelectric material), for example, an oxide of a Perovskite structure having a high dielectric constant, such as PbZrTiO₃ (PZT) or BaSrTiO₃ (BST), has recently been proposed. The ferroelectric material has a spontaneous polarization phenomenon, unlike a conventional dielectric film such as a silicon oxide film, a silicon nitride film or a tantalum oxide (Ta₂O₅) film, and a high dielectric constant of hundreds to approximately 1,000 under a bulk state. Even though the dielectric film of the ferroelectric material is formed to 500Å or thicker, the equivalent oxide thickness can be formed as thin as 10Å or less.

Meanwhile, in order to use the ferroelectric material as the dielectric film of a capacitor, the electrode material formed on and under the dielectric film is important. The following conditions must be met for an electrode material of a capacitor using a ferroelectric material. First, a film of a Perovskite structure should be formed on the electrode. Second, a low dielectric film should not be formed on a interface between the electrode and a film having the ferroelectric material. Third, silicon or components of the ferroelectric material should not be mutually diffused. Fourth, the electrode should be easy to pattern. Platinum group metals having oxidation-resistance and high conductivity can be used such as Platinum (Pt), Ruthenium (Ru) or Iridium (Ir), and a conductive oxide such as IrO₂ or RuO₂ for electrodes of the capacitor in which the ferroelectric material is used as the dielectric film.

Meanwhile, in a memory device including a conventional capacitor, which uses both an oxide/nitride/oxide (ONO) film as the dielectric film and electrodes formed of polysilicon, a resistor of a periphery region is formed of material for forming an upper electrode of the capacitor. However, in the case that the capacitor having a ferroelectric material in which electrodes formed of the platinum group metals or an oxide thereof are used as the upper electrode, the resistance of the electrodes is excessively low. Thus, the upper electrode of the capacitor cannot be used as the resistor of the periphery region.

In general, the resistor used for the memory device is used for a voltage generator and a RC delay in the periphery region, and requires a resistance of several of kΩ. In the case that the desired resistance is low, the resistor of the periphery region is formed of polysilicon for gate electrodes of a cell region, and in the case that the desired resistance is high, it is formed of polysilicon for an upper electrode of the capacitor. However, when the memory device is integrated to the order of several gigabytes, formation of the resistor is limited, which results from the fact that ferroelectric material such as BST or PZT is used for the dielectric film of the capacitor, and the above platinum group metals or the conductive oxide is used for the electrodes of the capacitor, to thereby make it difficult to obtain a sufficient resistance. Also, since for the gate electrode of a high-integrated memory device, a structure having low resistance such as a tungsten/silicide (WSiₓ) structure or a titanium silicide (TiSiₓ)/polysilicon structure is used, it is difficult to obtain a sufficient resistance.

In Table 1, sheet resistances of electrode material of the capacitor having ferroelectric material and gate electrode material are shown.

**(Table 1)**

| ELECTRODE MATERIAL (1500Å) | SHEET RESISTANCE (Ω/□) | GATE MATERIAL (1500Å) | SHEET RESISTANCE (Ω/□) |
|---|---|---|---|
| Platinum(Pt) | 0.71 | WSiₓ/poly-Si | 6 - 7 |
| Iridium(Ir) | 0.34 | TiSiₓ/poly-Si | 2 - 3 |
| Ruthenium(Ru) | 0.49 | poly-Si | about 100 |

As shown in Table 1, the sheet resistance of gate electrodes having a structure of a low resistance or the upper electrode is excessively low. Accordingly, in the case that the materials are used for a resistor of the periphery region, a length of the resistor which becomes longer in inverse proportion to the sheet resistance, makes it difficult to integrate. For example, in the case that 1µm of resistor width is used, in order to form a resistor of 1kΩ, polysilicon having a sheet resistance of 100 Ω/□ requires a length of 10µm, however, WSiₓ/polysilicon having a sheet resistance of 2 Ω/□ requires a length of 500µm. Thus, the resistor occupies much of the periphery region. Also, in the case that platinum (Pt) is used for the upper electrode of the ferroelectric material, the upper electrode of the capacitor cannot be used for the resistor of the periphery region.

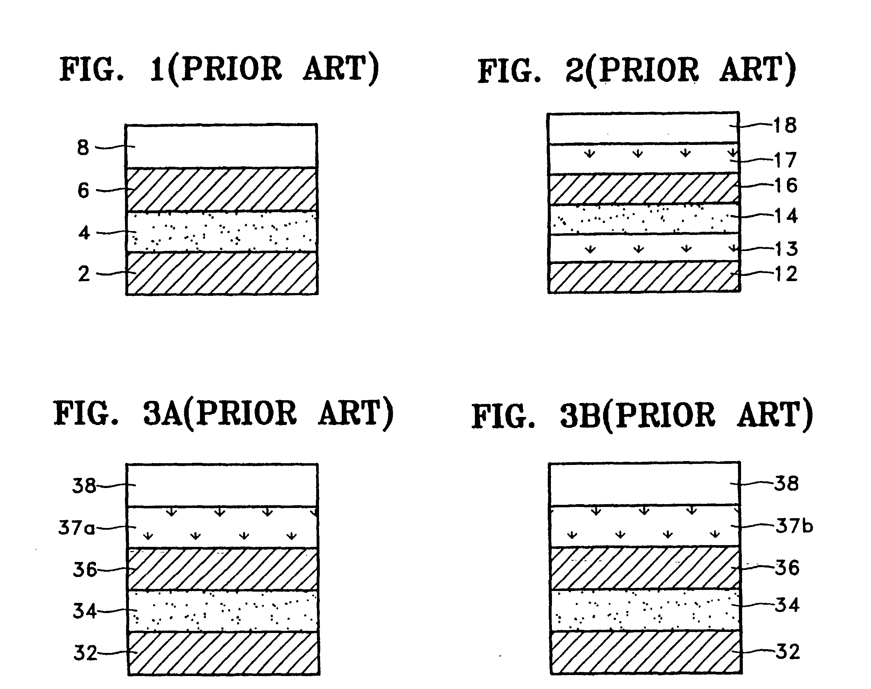

Referring to FIGs. 1 through 3B, a manufacturing method of a conventional capacitor having a ferroelectric material will be described.

FIG. 1 is a sectional view for illustrating a first conventional method for forming a capacitor having a ferroelectric material, which is described in "VLSI Technology Digest of Technical, pp. 149-150, in 1994 by Mitsubishi Co".

Referring to FIG. 1, the capacitor has a structure of Pt 2/BST 4/Pt 6. However, since platinum Pt has a low sheet resistance, the upper electrode 6 cannot be used for the resistor of the periphery region. Besides, adhesion of the platinum 6 of the upper electrode to an aluminum film 8 of an interconnection layer formed on the platinum layer 6 is poor.

FIG. 2 is a sectional view for illustrating a second conventional manufacturing method of a capacitor having a ferroelectric material, described in U.S. Patent No. 5,005,012.

In FIG. 2, a method of forming a multilayered upper electrode is shown. As shown in FIG. 2, a conductive barrier layer 17 is inserted between an upper electrode 16 and an interconnection metal layer 18. Compared to the structure shown in FIG. 1, the structure shown in FIG. 2 has advantage that the adhesive characteristic of the upper electrode 16 to the interconnection metal layer 18 is enhanced, whereas the structure has disadvantage that the upper electrode of the capacitor cannot be used as a resistor of the periphery region. Reference numeral 12 denotes a lower electrode, and reference numeral 13 denotes an adhesion/barrier layer for enhancing adhesion and preventing mutual reaction between the lower electrode 12 to a dielectric film 14.

FIG. 3A is a sectional view for illustrating a third conventional manufacturing method of a capacitor having a ferroelectric material described in Japanese Patent No. JP06-125057. Between a platinum layer 36 and an aluminum layer 38 of an interconnection metal layer, a metal layer 37a having a high melting point such as titanium nitride (TiN) and tungsten-titanium (TiW) is inserted, to thereby prevent mutual diffusion of Al and Pt. Reference numeral 32 denotes a lower electrode and reference numeral 34 denotes a dielectric film.

FIG. 3B is a sectional view for illustrating a fourth conventional manufacturing method of a capacitor having a ferroelectric material described in U.S. Patent No. 4,982,309. Between conductive oxide electrode 36 and a metal interconnection layer 38, a barrier layer 37b formed of a metal such as Ruthenium or Iridium, is inserted. Reference numeral 32 denotes a lower electrode and reference numeral 34 denotes a dielectric film.

Referring to FIGs. 3A and 3B, the upper electrode of the capacitor cannot be used for a resistor of a periphery region like in FIGs. 1 and 2. Also, in the case of FIG. 3A, the upper electrode, formed of platinum 36 and a metal layer 37a having a high melting point, contacts an interlayer insulating film (not shown), which is based on a silicon oxide such as Borophosphorus Silicate Glass (BPSG) or Undoped Silicate Glass (USG). Accordingly, thermal treating at 600°C or higher after the capacitor formation causes reaction of BPSG and TiN. The reaction of BPSG and TiN generate stress, to thereby deteriorate characteristics of the capacitor, which is disclosed in IEDM, 5-8 December 1993, pp. 53-56.

EP-A-0490240 describes a memory cell arrangement in which each cell comprises a switching transistor and a ferroelectric capacitor. A polysilicon layer is provided over the top electrode of the capacitor stack for connecting the top plate of the capacitor to a plate line.

US 5475248 also describes a memory cell arrangement comprising a switching transistor and a ferroelectric capacitor, in which an interconnection layer provides connection between the source of the transistor and the top electrode of the capacitor. The interconnection layer makes contact with the top electrode of the capacitor by means of a through-hole provided in an intermediate insulator layer. EP 0697720 discloses various materials for use as conductors and insulators in thin film semiconductor devices.

It is an object of the present invention to provide a semiconductor memory device in which an upper electrode can be used as a resistance layer of a periphery region and in which adhesion of the upper electrode to an interconnection layer is enhanced, and further, to prevent deterioration of characteristics of the capacitor by reducing stress between the upper electrode and the interlayer insulating film.

It is another object of the present invention to provide a manufacturing method of a semiconductor memory device.

According to a first aspect of the present invention, there is provided an integrated circuit ferroelectric memory device comprising: an integrated circuit substrate which includes a cell region including therein a plurality of ferroelectric memory cells and a periphery region that is laterally spaced apart from the plurality of ferroelectric memory cells in the cell region; the plurality of ferroelectric memory cells in the cell region including a plurality of ferroelectric capacitors, the ferroelectric capacitors comprising a lower electrodes, a ferroelectric layer on the lower electrode, and an upper electrode on the ferroelectric layer opposite the lower electrode; a first material layer having sheet resistance of between about 5 and 500 Ω/□ comprising material that is different from the upper electrodes, on the upper electrodes in the cell region opposite the ferroelectric layer, and on the integrated circuit substrate in the periphery region, the first material layer forming a plurality of resistors in the periphery region; an interlayer insulating film on the first material layer including a contact hole; and an interconnection layer on the interlayer insulating film including in the contact hole.

The upper and lower electrodes may comprise material selected from the group consisting of a platinum group metal and a conductive oxide.

The dielectric film may be formed of an oxide having Perovskite structure such as PZT, PbTiO₃, PbLaTiO₃, BaTiO₃, Bi₄Ti₃O₁₂, SrBi₂Ta₂O₉, BST (BaSrTiO₃) and STO (SrTiO₃).

The first material layer may further comprise a first barrier layer and the interconnection layer on the first barrier layer, wherein the first barrier layer prevents reaction of the first material layer and the interconnection layer. Also, a second barrier layer can be formed to prevent reaction of the upper electrode and first material layer between the upper electrode and first material layer.

The invention also provides a method of fabricating an integrated circuit ferroelectric memory device, comprising the steps of: defining in an integrated circuit substrate a cell region and a periphery region that is laterally spaced apart from the plurality of ferroelectric memory cells in the cell region ; fabricating a plurality of ferroelectric memory cells in the cell region, including a plurality of ferroelectric capacitors, the ferroelectric capacitors comprising a lower electrode, a ferroelectric layer on the lower electrode, and an upper electrode on the ferroelectric layer opposite the lower electrode; forming a first material layer with a sheet resistance of between 5 and 500 Ω/□, comprising material that is different from the upper electrodes, on the upper electrodes in the cell region opposite the ferroelectric layer, and on the integrated circuit substrate in the periphery region, the first material layer forming a plurality of resistors in the periphery region; forming an interlayer insulating layer on the first material layer, including a contact hole which exposes the first material layer; and forming an interconnection layer on the interlayer insulating layer, including in the contact. hole.

An example of the present invention will now be described in detail with reference to the accompanying drawings, in which:
FIG. 1 is a sectional view for illustrating a first conventional manufacturing method of a capacitor having ferroelectric material;
FIG. 2 is a sectional view for illustrating a second conventional manufacturing method of a capacitor having ferroelectric material;
FIG. 3A is a sectional view for illustrating a third conventional manufacturing method of a capacitor having ferroelectric material;
FIG. 3B is a sectional view for illustrating a fourth conventional manufacturing method of a capacitor having ferroelectric material;
FIG. 4 is a sectional view of a semiconductor memory device having a capacitor having ferroelectric material according to the present invention;
FIGs. 5A through 5G are sectional views sequentially showing a manufacturing method of the semiconductor memory device according to a first embodiment;
FIG. 6 is a sectional view for illustrating a manufacturing method of the semiconductor memory device according to a second embodiment; and
FIG. 7 is a sectional view for illustrating a manufacturing method of the semiconductor memory device according to a third embodiment.

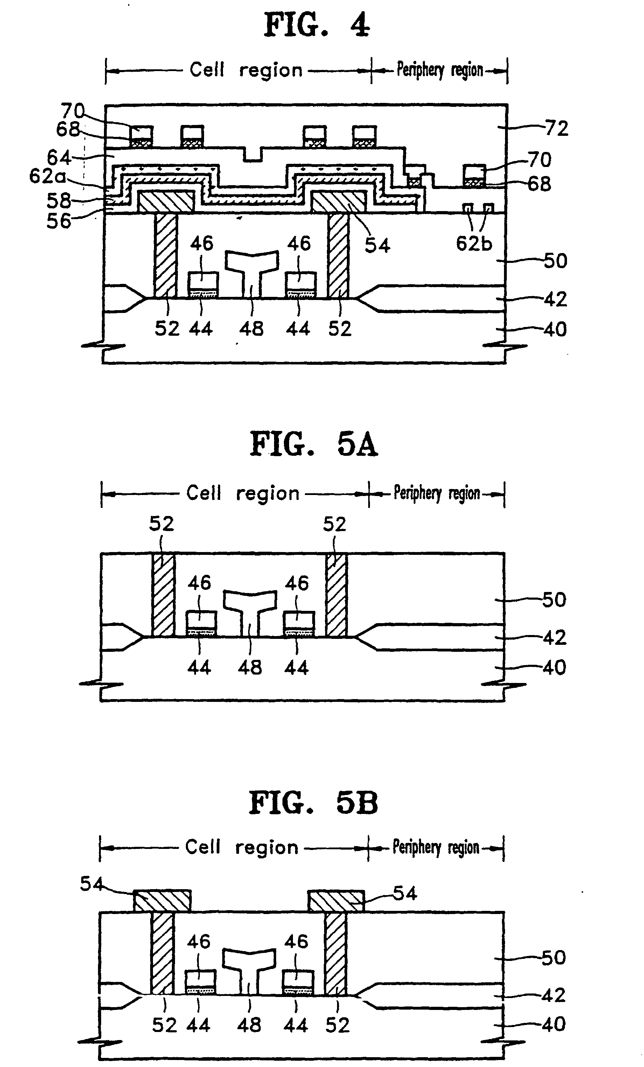

Referring to FIG. 4, reference numeral 40 denotes a semiconductor substrate, reference numeral 42 denotes a field oxide film for defining an active region and a non-active region, reference numeral 44 denotes a gate insulating film of an oxide film, a nitride film or an ONO film, reference numeral 46 denotes a gate of polysilicon or polycide, reference numeral 48 denotes a bit line connected to a drain of a transistor (not shown), reference numerals 50 and 64 denote interlayer insulating films, reference numeral 52 denotes a plug for connecting a lower electrode of a capacitor to a source of the transistor (not shown), reference numeral 54 denotes a lower electrode of the capacitor, reference numeral 56 denotes a dielectric film, reference numeral 58 denotes an upper electrode of the capacitor, reference numeral 62a denotes a first material layer formed of a semiconductor or an insulator, reference numeral 62b denotes a resistor of a periphery region formed of a semiconductor or an insulator, reference numeral 68 denotes a barrier layer, reference numeral 70 denotes an interconnection layer and reference numeral 72 denotes a protective film.

On the semiconductor substrate, a capacitor having ferroelectric material including the lower electrode 54, the dielectric film 56 and the upper electrode 58, the upper and lower electrodes 58 and 54 are formed of a material selected from the group consisting of Pt, Ru, Ir, Pd, IrO₂, a platinum oxide, an osmium oxide, an indium oxide, an Indium Tin Oxide (ITO) and RuO₂.

The dielectric film 56 is formed of one selected from the group consisting of an oxide having a Perovskite structure such as PZT, PbTiO₃, PbLaTiO₃, BaTiO₃, BaSrTiO₃ and SrTiO₃ or Bi₄Ti₃O₁₂ and SrBi₂Ta₂O₉.

On the upper electrode 58, first material layers 62a and 62b, which can enhance adhesion of an interconnection layer to the upper electrode and can be used as a resistor of the periphery region and are formed of a semiconductor or an insulator having sheet resistance of approximately 5 ∼ 500 Ω/□, are formed. Preferably, the first material layers 62a and 62b are formed of one selected from the group consisting of a semiconductor such as polysilicon or WSix, and an insulator such as SiN, Al₂O₃, TiSi₂N_{y}, TaSiₓN_{y} and TiₓAl_{y}N_{z}.

In the case that the first material layers 62a and 62b are formed of a semiconductor such as polysilicon or silicide, a contact hole for connecting the interconnection layer 70 of a cell region to the first material layer thereof may be formed directly on a surface of the first material layer 62a. Here, in order to prevent mutual reaction and to form ohmic contact between the first material layer 62a and the interconnection layer 70, preferably, a first barrier layer 68 can be further included. The first barrier layer 68 is formed of one selected from the group consisting of a double film of Ti/TiN, TiSiₓN_{y}, TaSiₓN_{y}, Ir and IrO₂.

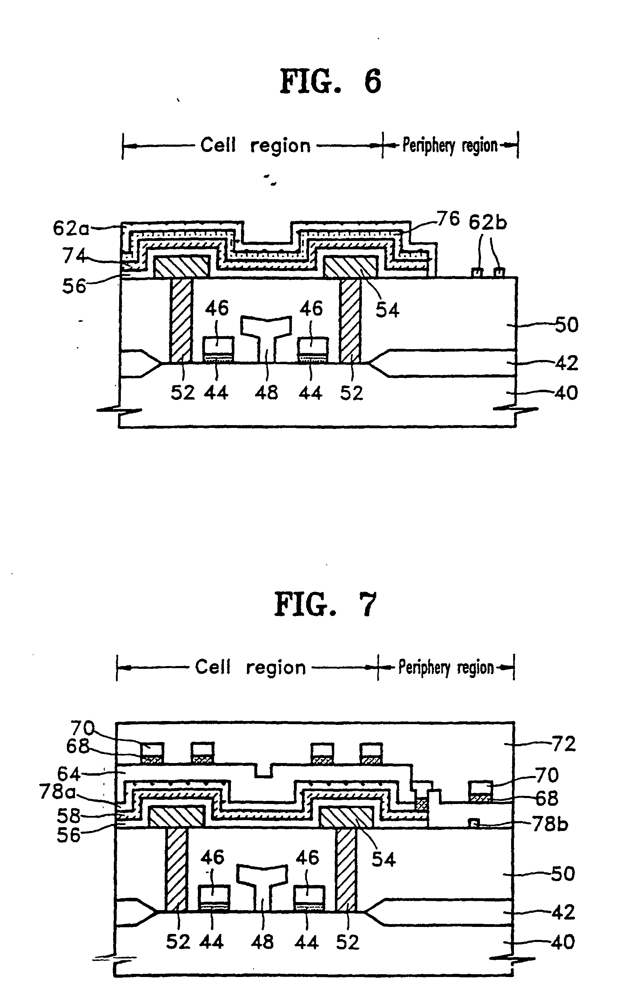

Also, as shown in FIG. 6, between the upper electrode 74 and the first material layer 62a of the cell region, a second harrier layer 76 for preventing mutual reaction of the upper electrode and the first material layer may be further included. The second barrier layer 76 can be formed of the same material as that of the first barrier layer 68.

In FIG. 7, first material layers 78a and 78b formed between an upper electrode 58 and an interconnection layer 70 can be formed of an insulator instead of a semiconductor such as polysilicon.

In the semiconductor memory device of the present invention, the first material layer formed of a semiconductor or an insulator having sheet resistance, which can be used for a resistor of a periphery region, is further included between the upper electrode of the capacitor having ferroelectric material and the interconnection layer. Thus, the adhesion of the interconnection layer to the upper electrode of the capacitor can be enhanced, and the first material layer can form the resistor of the periphery region.

### Embodiment 1

FIG. 5A shows the step of forming a transistor and a contact hole.

The step is performed by forming an isolation film for isolating a semiconductor substrate into an active region and a non-active region, forming a transistor at the active region of the semiconductor substrate, forming a bitline connected to a drain of the transistor, forming an interlayer insulating film on the resultant structure where the bitline is formed, and forming a plug for connecting a source of the transistor and a lower electrode of the capacitor.

In detail, a field oxide film 42 is formed on a semiconductor substrate 40 using a typical isolation process such as local oxidation of silicon (LOCOS), and then a transistor having a gate insulating film 44, a gate electrode 46 and a source/drain (not shown) are formed in a usual manner. Subsequently, a bitline 48 contacting the drain of the transistor is formed, and then an insulating film is deposited on the entire surface of the resultant structure where the bitline 48 is formed, to thereby form an interlayer insulating film 50. Then, the interlayer insulating film 50 is partially etched, to thereby form a contact hole. The contact hole is filled with conductive material, to thereby form a plug 52 for connecting a source of the transistor to the lower electrode of the capacitor.

FIG. 5B shows the step of forming lower electrode 54 of the capacitor.

The step is performed by depositing a platinum group metal or a conductive oxide, thereby forming a conductive layer, and patterning the conductive layer.

In detail, conductive material for forming the lower electrode of the capacitor on the resultant structure, where the plug 52 is formed, is deposited to a thickness of approximately 100 ∼ 3,000Å (1Å=0.1mm), to thereby form a conductive layer. Then, the conductive layer is patterned using a conventional photolithography method, to thereby form the lower electrode 54 of the capacitor.

The material for forming the lower electrode 54 of the capacitor is, one selected from. the group consisting of a conductive material having high conductivity and oxidation-resistance such as Pt, Ru, Ir, Pd or Os, a conductive oxide such as IrO₂, platinum oxide (PtO), Osmium oxide (OsO₂), Indium oxide (In₂O₃), Indium Tin Oxide (ITO), RuO₂, and a combination of the conductive material with the conductive oxide.

A sputtering or chemical vapor deposition (CVD) is used to deposit the electrode material. For example, in order to deposit a platinum metal group by sputtering, the metal is used as a target under an argon (Ar) atmosphere, at a substrate temperature of 20 ∼ 500°C and at a chamber pressure of 1 ∼ 10mTorr (1 Torr = 133.32 Nm⁻²). To deposit a platinum group metal oxide by radio frequency (RF) sputtering or reactive sputtering, the metal is used as a target under an atmosphere of mixed gases of Ar with O₂ of 5 ∼ 50% and further, at a chamber pressure of 1 ∼ 10mTorr. To deposit platinum by a CVD method, platinum-hexafluoroacetyl acetonate (Pt-HFA)₂ is used as a platinum source. Here, Ar of 100 ∼ 1,000sccm is provided at a chamber pressure of 10mTorr ∼ 10Torr and at substrate temperature of 100 ∼ 500°C.

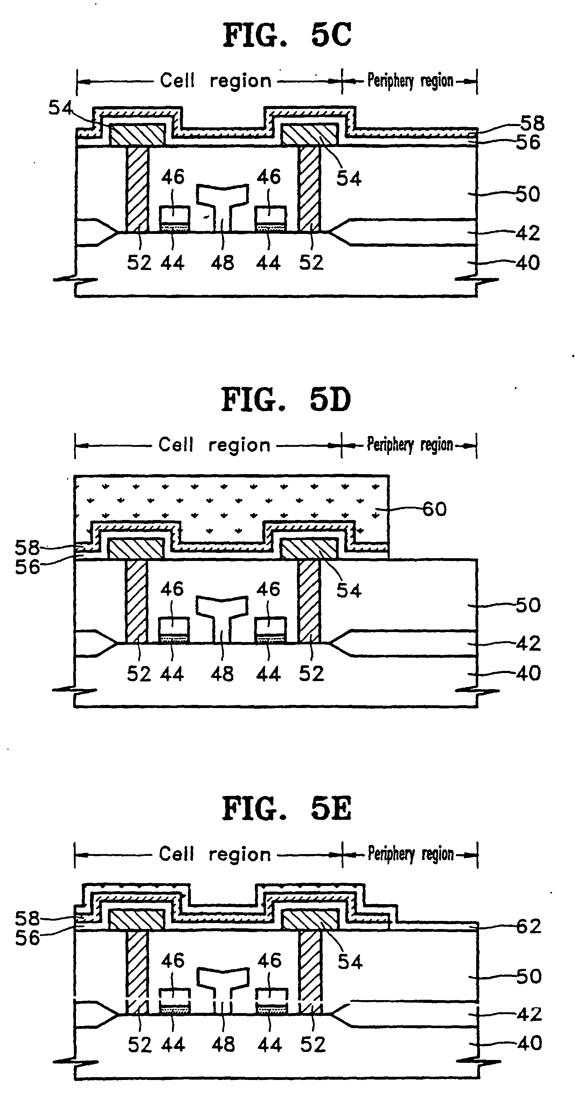

FIG. 5C shows the step of forming a dielectric film 56 and a conductive layer 58 for an upper electrode of a capacitor.

The step is performed by depositing ferroelectric material on the resultant structure of FIG. 5B, thereby forming a dielectric film, and depositing a platinum group metal or a platinum oxide, thereby forming a conductive layer.

In detail, ferroelectric material such as PZT, is deposited on the resultant structure where a lower electrode of the capacitor is formed, by sputtering or CVD, thereby forming the dielectric film 56. Then, a platinum group metal or a conductive oxide, is deposited on the dielectric film in the same manner as that for forming the lower electrode 54, to thereby form the conductive layer 58 for an upper electrode.

The material for forming the dielectric film 56, one selected from the group consisting of an oxide having a Perovskite structure such as PZT, PbTiO₃, PbLaTiO₃, BaTiO₃, BST (BaSrTiO₃) and STO (SrTiO₃) or Bi₄Ti₃O₁₂, SrBi₂Ta₂O₉ can be used.

For example, in order to deposit the BST by sputtering, BST is used as a target under Ar and O₂ atmosphere. Here, a substrate temperature of 450 ∼ 650°C and a chamber pressure of 1 ∼ 10mTorr are maintained. In order to deposit the BST by CVD, Ba(DPM)₂, Sr(DPM)₂ or Ti(DPM)₂ is used as a main component of the CVD source and an oxide gas including O₂_ and N₂O of 10 ∼ 50% with Ar is provided into the chamber, in which the substrate temperature is 450 ∼ 800°C and the chamber pressure is 0.1 ∼ 10Torr.

FIG. 5D shows the step of photolithography for patterning the conductive layer 58 for an upper electrode.

The step is performed by forming a photo resist pattern on the conductive layer for the upper electrode and patterning the conductive layer for the upper electrode and the dielectric film.

In detail, a material such as a photo resist for forming a mask layer on the resultant structure, where the conductive layer 58 is formed for the upper electrode, photo resist is spin-coated to a thickness of 0.5 - 5µm, and then the coated photo resist is exposed and developed, thereby forming a photo resist pattern 60 for exposing the conductive layer 58 for the upper electrode of the periphery region.

Then, the conductive layer 58 for the upper electrode of the periphery region and the dielectric film 56 thereof are etched, using the photo resist pattern 60 as a mask. Here, the conductive layer 58 for the upper electrode can be etched by wet or dry etching. As the etchant, a mixture of HCl and HNO₃ can be used for wet-etching, or a mixed gas of O₂ and Cl₂ can be used for the dry-etching.

FIG. 5E shows the step of forming a first material layer 62.

The step is performed by removing the photo resist pattern and depositing polysilicon on the resultant structure where the photo resist pattern is removed.

In detail, the photo resist pattern is eliminated, and then on the entire surface of the resultant structure of the cell region and the periphery region, a semiconductor or insulator such as polysilicon, which can be used as a resistor of the periphery region, is deposited, to thereby form the first material layer 62. The first material layer 62 can be used as a barrier layer for enhancing adhesion of the upper electrode to the interconnection layer in the cell region and can be used for a resistor in the periphery region.

In order to form a polysilicon film for the first material layer 62, SiH₄ or SiH₂Cl₂ is used as a source and a dopant source including PH₃ is implanted into a chamber, and a CVD method is used at a substrate temperature of 550 ∼ 750°C.

The thickness and doping concentration of the polysilicon film 62 should be controlled appropriately such that the sheet resistance of the polysilicon film is 5 ∼ 500 Ω/□, which is the sheet resistance Rs required for resistance of the periphery region. It is preferred that the thickness of the polysilicon film is approximately 100 ∼ 3,000Å. Here, in order to obtain the appropriate sheet resistance, the doping concentration of the polysilicon film is controlled by adding a dopant into the chamber during a CVD process or depositing undoped polysilicon, and then performing ion-implantation or diffusion.

Here, silicide such as WSiₓ TiSiₓ, TiSiₓN_{y} and TaSiₓN_{y} or an insulating film such as SiN or Al₂O₃, instead of the polysilicon film 62, can be used.

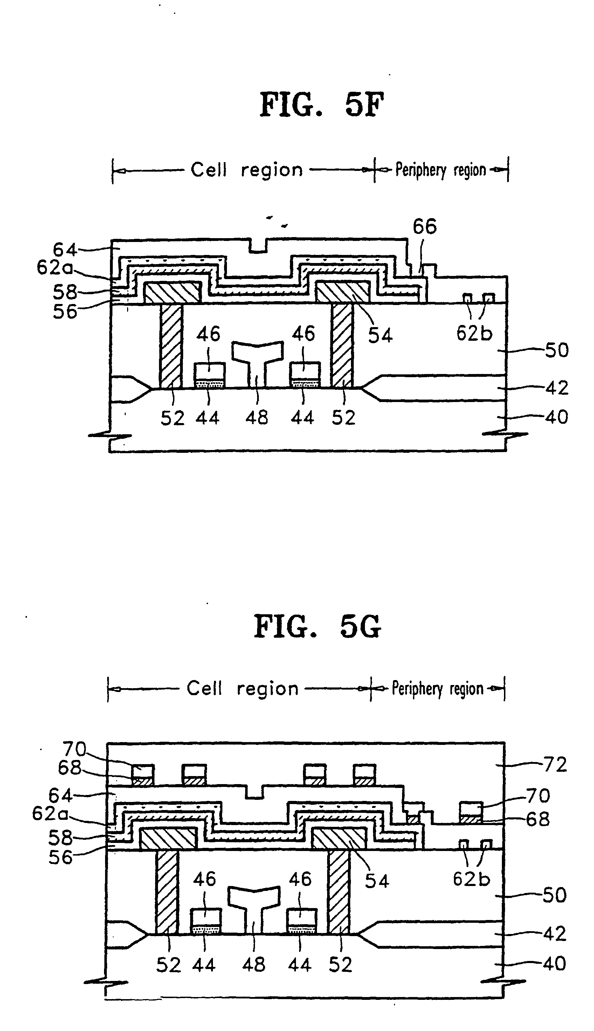

FIG. 5F shows the step of forming an interlayer insulating film 64 and a contact hole 66.

The step is performed by patterning a polysilicon film, depositing an insulator on the patterned polysilicon, thereby forming the interlayer insulating film, and etching the interlayer insulating film, thereby forming a contact hole for connecting the upper electrode of the capacitor and the interconnection layer thereof.

In detail, the first material layer is patterned by a conventional photolithography, to thereby form a first material layer pattern, which can be used for the barrier layer 62a for enhancing adhesion of the upper electrode 58 of the capacitor to the interconnection layer thereof, and can be used for the resistor 62b having a predetermined resistance in the periphery region. Then, one selected from the group consisting of BPSG, PSG, SG, SOG, USG, and a combination thereof, is deposited on the resultant structure to a predetermined thickness of approximately 2,000 ∼ 10,000Å, to thereby form an interlayer insulating film 64.

Then, the interlayer insulating film 64 is partially etched by photolithography, to thereby form a contact hole 66 for connecting the upper electrode of the capacitor to the interconnection layer thereof. Here, the contact hole 66 can be formed, with a surface of the first material layer 62a exposed or with a surface of the upper electrode layer 58 portion under the first material layer exposed.

FIG. 5G shows the step of forming a barrier layer 68, an interconnection layer 70 and a protective film 72.

The step is performed by forming the barrier layer 68 on the resultant structure where the contact hole is formed, and depositing interconnection metal on the resultant structure, thereby forming the interconnection layer 70, patterning the interconnection layer and the barrier layer, and forming the protective film 72 on the resultant structure.

In detail, on the resultant structure where the contact hole is formed, a material selected from the group consisting of a double film of Ti/TiN, TiSiₓN_{y}, TaSiₓN_{y}, Ir and IrO₂ is deposited to a thickness of 100 ∼ 1,000Å, to thereby form the barrier layer 68 for preventing mutual diffusion of the first material layer 62a and the interconnection layer and forming an ohmic contact between the first material layer 62a and the interconnection layer. Sequentially, on the resultant structure where the barrier layer is formed, a metal such as Aluminum for interconnection, is deposited to a thickness of approximately 3,000 ∼ 10,000Å, and then the barrier layer 68 and the interconnection layer 70 are patterned by photolithography. Then, a process of forming the protective layer 72 and a succeeding process are performed by a typical manufacturing process of a DRAM.

In this first embodiment, on the upper electrode layer of the capacitor having ferroelectric material, a resistor of the periphery region is deposited. Thus, the resistor of the periphery region can be concurrently formed during formation of the capacitor, and adhesion of the upper electrode layer to the interconnection layer is enhanced, and further reliability can be enhanced. Also, the first material layer prevents stress due to reaction with an interlaver insulating film to be deposited.

### Embodiment 2

Referring to FIG. 6, the corresponding material layers are denoted by reference numerals used in the first embodiment.

The second embodiment is suitable for preventing the mutual diffusion of an upper electrode of a capacitor and a first material layer, i.e., for forming the upper electrode by Pt.

The manufacturing method of this embodiment involves the processes of forming a first barrier layer which is formed of Platinum on an upper electrode layer 74, forming the first material layer on the first barrier layer, exposing the first material layer of the periphery region by photolithography and patterning the first material layer, the first barrier layer and the upper electrode layer.

In detail, by the same method as that of the first embodiment, a Platinum layer 74 is formed as a conductive layer for the upper electrode. Then, in order to prevent reaction of the Pt layer 74 and a polysilicon film 62a formed at the first material layer, material for preventing reaction of Pt and polysilicon, i.e., TiN, Ir, IrO₂, RuO₂ or Ru, TiSiₓN_{y}, TaSiₓN_{y} is deposited on the platinum layer 74 to a thickness of 100 ∼ 1,000Å by sputtering, to thereby form a first barrier layer 76. Here, the processes of forming the polysilicon film, patterning the upper electrode layer, or forming a contact hole, which are performed by the same method as that in the first embodiment, will not be described.

According to the manufacturing method of a capacitor having ferroelectric material of the second embodiment, in addition to a first material layer, which is used for a resistor of a periphery region, a barrier layer for preventing the mutual reaction of the first material layer and the upper electrode layer is also formed, to thereby enhance reliability.

### Embodiment 3

Referring to FIG. 7, the corresponding material layers are denoted by reference numerals used in the first and second embodiments.

The third embodiment is suitable for cases where an insulator instead of a semiconductor such as polysilicon is used as the first material layers 78a and 78b formed between the upper electrode 58 and the interconnection layer 70. Here, the insulator is SiO₂, Al₂ O₃ or SiN. Other processes performed by the same method as that in the first embodiment will not be described. However, in the case where the insulator instead of the semiconductor is used, as shown in FIG. 7, a contact hole for connecting the interconnection layers 68 and 70 to the upper electrode 58 in a cell region, is formed by etching the insulator layer 78a to expose a surface of the upper electrode 58.

In a semiconductor memory device having a capacitor including ferroelectric material in accordance with the present invention, a semiconductor layer or an insulator layer is deposited on the upper electrode of the capacitor. Accordingly, the semiconductor layer or the insulation layer can be used for a resistor of a periphery region without deterioration of capacitor characteristics, adhesion of the upper electrode to the interconnection layer can be enhanced, and adhesion of the upper electrode to a dielectric film is improved. Also, a layer without stress, which is caused by a reaction with the interlayer insulating film, is formed between the electrode and the interlayer insulating film, to thereby prevent deterioration of capacitance in a subsequent process.

## Claims

1. An integrated circuit ferroelectric memory device comprising:
an integrated circuit substrate which includes a cell region including therein a plurality of ferroelectric memory cells and a periphery region that is laterally spaced apart from the plurality of ferroelectric memory cells in the cell region;
the plurality of ferroelectric memory cells in the cell region including a plurality of ferroelectric capacitors, the ferroelectric capacitors comprising a lower electrode, a ferroelectric layer on the lower electrode, and an upper electrode on the ferroelectric layer opposite the lower electrode;
a first material layer having sheet resistance of between about 5 and 500 Ω/□ comprising material that is different from the upper electrodes, on the upper electrodes in the cell region opposite the ferroelectric layer, and on the integrated circuit substrate in the periphery region, the first material layer forming a plurality of resistors in the periphery region;
an interlayer insulating film on the first material layer including a contact hole; and
an interconnection layer on the interlayer insulating film including in the contact hole.

2. An integrated circuit ferroelectric memory device according to claim 1, wherein the upper and lower electrodes comprise material selected from the group consisting of a platinum group metal and a conductive oxide.

3. An integrated circuit ferroelectric memory device according to claim 2, wherein the platinum group metal is selected from the group consisting of Pt, Ru, Ir, Pd and Os.

4. An integrated circuit ferroelectric memory device according to claim 2, wherein the conductive oxide is selected from the group consisting of IrO₂, Platinum oxide, Osmium oxide, Indium oxide, Indium Tin Oxide(ITO) and RuO₂.

5. An integrated circuit ferroelectric memory device according to claim 1, wherein the ferroelectric layer comprises material selected from the group consisting of an oxide having Perovskite structure, Bi₄Ti₃O₁₂ and SrBi₂Ta₂O₉.

6. An integrated circuit ferroelectric memory device according to claim 5, wherein the oxide having Perovskite structure is selected from the group consisting of PZT, PbTiO₃, PbLaTiO₃, BaTiO₃, BST(BaSrTiO₃) and STO(SrTiO₃).

7. An integrated circuit ferroelectric memory device according to claim 1, wherein the first material layer comprises material selected from the group consisting of polysilicon, tungsten silicide, SiN, Al₂O₃, TiSiₓN_{y} and TaSiₓN_{y}.

8. An integrated circuit ferroelectric memory device according to claim 1, further comprising a first barrier layer on the first material layer, and an interconnection layer on the first barrier layer, wherein the first barrier layer prevents reaction between the first material layer and the interconnection layer.

9. An integrated circuit ferroelectric memory device according to claim 8, wherein the first barrier layer is selected from the group consisting of a double film of Ti/TiN, Ir, Ru, RuO₂, TiSiₓN_{y} and IrO₂.

10. An integrated circuit ferroelectric memory device according to claim 1, further comprising a barrier layer between the upper electrode and the first material layer, which prevents reaction between the upper electrode and first material layer.

11. An integrated circuit ferroelectric memory device according to claim 10, wherein the barrier layer is selected from the group consisting of Ti/TiN, Ir, Ru, RuO₂, TiSiₓN_{y}, and TaSiₓN_{y}.

12. An integrated circuit ferroelectric memory device according to claim 8, further comprising a second barrier layer between the upper electrode and the first material layer, which prevents reaction between the upper electrode and first material layer.

13. An integrated circuit ferroelectric memory device according to claim 1, wherein the first material layer promotes adhesion between the upper electrode and the interconnection layer.

14. An integrated circuit ferroelectric memory device according to claim 1, wherein the first material layer promotes adhesion between the upper electrode and the insulating layer.

15. A method of fabricating an integrated circuit ferroelectric memory device, comprising the steps of:
defining in an integrated circuit substrate a cell region and a periphery region that is laterally spaced apart from the plurality of ferroelectric memory cells in the cell region;
fabricating a plurality of ferroelectric memory cells in the cell region, including a plurality of ferroelectric capacitors, the ferroelectric capacitors comprising a lower electrode, a ferroelectric layer on the lower electrode, and an upper electrode on the ferroelectric layer opposite the lower electrode;
forming a first material layer with a sheet resistance of between 5 and 500 Ω/□ comprising material that is different from the upper electrodes, on the upper electrodes in the cell region opposite the ferroelectric layer, and on the integrated circuit substrate in the periphery region, the first material layer forming a plurality of resistors in the periphery region;
forming an interlayer insulating layer on the first material layer, including a contact hole which exposes the first material layer; and
forming an interconnection layer on the interlayer insulating layer, including in the contact hole.

16. A method according to claim 15, wherein the first material layer forming step is followed by the steps of:
forming said interlayer insulating layer on the first material layer, including a contact hole which exposes the upper electrode; and
forming said interconnection layer on the interlayer insulating layer, including in the contact hole.

17. A method according to claim 15, wherein the upper and lower electrodes comprises material selected from the group consisting of a platinum group metal and a conductive oxide.

18. A method according to claim 17, wherein the platinum group metal is selected from the group consisting of Pt, Ru, Ir, Pd and Os.

19. A method according to claim 17, wherein the conductive oxide is selected from the group consisting of IrO₂, Platinum oxide, Osmium oxide, Indium oxide, Indium Tin Oxide (ITO) and RuO₂.

20. A method according to claim 17, wherein the ferroelectric layer comprising material selected from the group consisting of an oxide having Perovskite structure, Bi₄Ti₃O₁₂ and SrBi₂Ta₂O₉.

21. A method according to claim 20, wherein the oxide having Perovskite structure is selected from the group consisting of PZT, PbTiO₃, PbLaTiO₃, BaTiO₃, BST(BaSrTiO₃) and STO(SrTiO₃).

22. A method according to claim 15, wherein the first material layer is selected from the group consisting of polysilicon, tungsten silicide, SiN, Al₂O₃, TiSiₓN_{y} and TaSiₓN_{y}, and Al₂O₃.

23. A method according to claim 15, wherein the step of forming a first material layer is followed by the step of forming a first barrier layer on the first material layer to prevent reaction of the first material layer and the interconnection layer.

24. A method according to claim 23, wherein the first barrier layer is selected from the group consisting of a double film of Ti/TiN, TiSiₓN_{y}, TaSiₓN_{y}, Ir, IrO₂, Ru and RuO₂.

25. A method according to claim 15, wherein the following step is performed prior to the step of forming a first material layer;
forming a barrier layer on the upper electrode to prevent reaction between the upper electrode and the first material layer.

26. A method according to claim 25, wherein the second barrier layer is selected from the group consisting of Ti/TiN, Ir, Ru, RuO₂, TiSiₓN_{y} and TaSiₓN_{y}.

27. A method according to claim 23, wherein the following step is performed prior to the step of forming a first material layer;
forming a second barrier layer on the upper electrode to prevent reaction beween the upper electrode and the first material layer.

## Patentansprüche

1. Ferroelektrische Speichervorrichtung für eine integrierte Schaltung umfassend:
ein Substrat für eine integrierte Schaltung, das eine Zellenregion aufweist, die darin eine Vielzahl von ferroelektrischen Speicherzellen aufweist und eine Peripherieregion, die von der Vielzahl von ferroelektrischen Speicherzellen in der Zellenregion seitlich beabstandet ist;
wobei die Vielzahl von ferroelektrischen Speicherzellen in der Zellenregion eine Vielzahl von ferroelektrischen Kondensatoren aufweist, wobei die ferroelektrischen Kondensatoren eine untere Elektrode, eine ferroelektrische Schicht auf der unteren Elektrode und eine obere Elektrode auf der ferroelektrischen Schicht gegenüber der unteren Elektrode aufweisen;
eine erste Materialschicht mit einem Schichtwiderstand zwischen ungefähr 5 und 500 Ω/□ umfassend Material, das sich von den oberen Elektroden unterscheidet, auf den oberen Elektroden in der Zellenregion gegenüber der ferroelektrischen Schicht und auf dem Substrat der integrierten Schaltung in der Peripherieregion, wobei die erste Materialschicht eine Vielzahl von Widerständen in der Peripherieregion bildet;
einen Zwischenschichtisolierfilm auf der ersten Materialschicht, die einen Kontaktdurchtritt aufweist; und
eine Verbindungsschicht auf dem Zwischenschichtisolierfilm, der den Kontaktdurchtritt aufweist.

2. Ferroelektrische Speichervorrichtung für eine integrierte Schaltung nach Anspruch 1, worin die oberen und unteren Elektroden Material umfassen, das ausgewählt ist aus der Gruppe bestehend aus einem Platingruppenmetall und einem leitfähigen Oxid.

3. Ferroelektrische Speichervorrichtung für eine integrierte Schaltung nach Anspruch 2, worin das Platingruppenmetall ausgewählt ist aus der Gruppe bestehend aus Pt, Ru, Ir, Pd und Os.

4. Ferroelektrische Speichervorrichtung für eine integrierte Schaltung nach Anspruch 2, worin das leitfähige Oxid ausgewählt ist aus der Gruppe bestehend aus IrO₂, Platinoxid, Osmiumoxid, Indiumoxid, Indiumzinnoxid (ITO) und RuO₂.

5. Ferroelektrische Speichervorrichtung für eine integrierte Schaltung nach Anspruch 1, worin die ferroelektrische Schicht Material umfasst, das ausgewählt ist aus der Gruppe bestehend aus einem Oxid mit Perovskitstruktur, Bi₄Ti₃O₁₂ und SrBi₂Ta₂O₉.

6. Ferroelektrische Speichervorrichtung für eine integrierte Schaltung nach Anspruch 5, worin das Oxid mit Perovskitstruktur ausgewählt ist aus der Gruppe bestehend aus PZT, PbTiO₃, PbLaTiO₃, BaTiO₃, BST (BaSrTiO₃) und STO (SrTiO₃).

7. Ferroelektrische Speichervorrichtung für eine integrierte Schaltung nach Anspruch 1, worin die erste Materialschicht Material umfasst, das ausgewählt ist aus der Gruppe bestehend aus Polysilicium, Wolframsilicid, SiN, Al₂O₃, TiSiₓN_{y} und TaSiₓN_{y}.

8. Ferroelektrische Speichervorrichtung für eine integrierte Schaltung nach Anspruch 1, ferner umfassend eine erste Barriereschicht auf der ersten Materialschicht und eine Verbindungsschicht auf der ersten Barriereschicht, worin die erste Barriereschicht eine Reaktion zwischen der ersten Materialschicht und der Verbindungsschicht verhindert.

9. Ferroelektrische Speichervorrichtung für eine integrierte Schaltung nach Anspruch 8, worin die erste Barriereschicht ausgewählt ist aus der Gruppe bestehend aus einem Doppelfilm aus Ti/TiN, Ir, Ru, RuO₂, TiSiₓN_{y} und IrO₂.

10. Ferroelektrische Speichervorrichtung für eine integrierte Schaltung nach Anspruch 1, ferner umfassend eine Barriereschicht zwischen der oberen Elektrode und der ersten Materialschicht, die eine Reaktion zwischen der oberen Elektrode und der ersten Materialschicht verhindert.

11. Ferroelektrische Speichervorrichtung für eine integrierte Schaltung nach Anspruch 10, worin die Barriereschicht ausgewählt ist aus der Gruppe bestehend aus Ti/TiN, Ir, Ru, RuO₂, TiSiₓN_{y} und TaSiₓN_{y}.

12. Ferroelektrische Speichervorrichtung für eine integrierte Schaltung nach Anspruch 8, ferner umfassend eine zweite Barriereschicht zwischen der oberen Elektrode und der ersten Materialschicht, die eine Reaktion zwischen der oberen Elektrode und der ersten Materialschicht verhindert.

13. Ferroelektrische Speichervorrichtung für eine integrierte Schaltung nach Anspruch 1, worin die erste Materialschicht Adhäsion zwischen der oberen Elektrode und der Verbindungsschicht begünstigt.

14. Ferroelektrische Speichervorrichtung für eine integrierte Schaltung nach Anspruch 1, worin die erste Materialschicht Adhäsion zwischen der oberen Elektrode und der Isolierschicht begünstigt.

15. Verfahren zur Herstellung einer ferroelektrischen Speichervorrichtung für eine integrierte Schaltung umfassend die Schritte:
Definieren einer Zellenregion und einer Peripherieregion, die von einer Vielzahl von ferroelektrischen Speicherzellen in der Zellenregion seitlich beabstandet ist, in einem Substrat für eine integrierte Schaltung;
Herstellen einer Vielzahl von ferroelektrischen Speicherzellen in der Zellenregion, die eine Vielzahl von ferroelektrischen Kondensatoren aufweisen, wobei die ferroelektrischen Kondensatoren eine untere Elektrode, eine ferroelektrische Schicht auf der unteren Elektrode und eine obere Elektrode auf der ferroelektrischen Schicht gegenüber der unteren Elektrode umfassen;
Ausbilden einer ersten Materialschicht mit einem Schichtwiderstand zwischen zwischen 5 und 500 Ω/□ umfassend Material, das sich von den oberen Elektroden unterscheidet, auf den oberen Elektroden in der Zellenregion gegenüber der ferroelektrischen Schicht und auf dem Substrat der integrierten Schaltung in der Peripherieregion, wobei die erste Materialschicht eine Vielzahl von Widerständen in der Peripherieregion bildet; Ausbilden einer Zwischenschichtisolierschicht auf der ersten Materialschicht, die einen Kontaktdurchtritt aufweist, der die erste Materialschicht freilegt; und
Ausbilden einer Verbindungsschicht auf der Zwischenschichtisolierschicht, die den Kontaktdurchtritt aufweist.

16. Verfahren nach Anspruch 15, worin der Schritt zum Ausbilden der ersten Materialschicht gefolgt ist von den Schritten:
Ausbilden der Zwischenschichtisolierschicht auf der ersten Materialschicht, die einen Kontaktdurchtritt aufweist, der die obere Elektrode freilegt; und
Ausbilden der Verbindungsschicht auf der Zwischenschichtisolierschicht, die den Kontaktdurchtritt aufweist.

17. Verfahren nach Anspruch 15, worin die obere und untere Elektrode Material umfassen, das ausgewählt wird aus der Gruppe bestehend aus einem Platingruppenmetall und einem leitfähigen Oxid.

18. Verfahren nach Anspruch 17, worin das Platingruppenmetall ausgewählt wird aus der Gruppe bestehend aus Pt, Ru, Ir, Pd und Os.

19. Verfahren nach Anspruch 17, worin das leitfähige Oxid ausgewählt wird aus der Gruppe bestehend aus IrO₂, Platinoxid, Osmiumoxid, Indiumoxid, Indiumzinnoxid (ITO) und RuO₂.

20. Verfahren nach Anspruch 17, worin die ferroelektrische Schicht Material umfasst, das ausgewählt wird aus der Gruppe bestehend aus einem Oxid mit Perovskitstruktur, Bi₄Ti₃O₁₂ und SrBi₂Ta₂O₉.

21. Verfahren nach Anspruch 20, worin das Oxid mit Perovskitstruktur ausgewählt wird aus der Gruppe bestehend aus PZT, PbTiO₃, PbLaTiO₃, BaTiO₃, BST (BaSrTiO₃) und STO (SrTiO₃).

22. Verfahren nach Anspruch 15, worin die erste Materialschicht ausgewählt wird aus der Gruppe bestehend aus Polysilicium, Wolframsilicid, SiN, Al₂O₃, TiSiₓN_{y} und TaSiₓN_{y} und Al₂O₃.

23. Verfahren nach Anspruch 15, worin der Schritt zum Ausbilden einer ersten Materialschicht gefolgt ist vom Schritt zum Ausbilden einer ersten Barriereschicht auf der ersten Materialschicht, um eine Reaktion der ersten Materialschicht und der Verbindungsschicht zu verhindern.

24. Verfahren nach Anspruch 23, worin die erste Barriereschicht ausgewählt wird aus der Gruppe bestehend aus einem Doppelfilm aus Ti/TiN, TiSiₓN_{y}, TaSiₓN_{y}, Ir, IrO₂, Ru und RuO₂.

25. Verfahren nach Anspruch 15, worin der folgende Schritt vor dem Schritt zum Ausbilden einer ersten Materialschicht durchgeführt wird;
Ausbilden einer Barriereschicht auf der oberen Elektrode, um eine Reaktion zwischen der oberen Elektrode und der ersten Materialschicht zu verhindern.

26. Verfahren nach Anspruch 25, worin die zweite Barriereschicht ausgewählt wird aus der Gruppe bestehend aus Ti/TiN, Ir, Ru, RuO₂, TiSiₓN_{y} und TaSiₓN_{y}.

27. Verfahren nach Anspruch 23, worin der folgende Schritt vor dem Schritt zum Ausbilden einer ersten Materialschicht durchgeführt wird;
Ausbilden einer zweiten Barriereschicht auf der oberen Elektrode, um eine Reaktion zwischen der oberen Elektrode und der ersten Materialschicht zu verhindern.

## Revendications

1. Dispositif de mémoire ferroélectrique à circuit intégré comprenant :
un substrat à circuit intégré qui comprend une région de cellule comprenant une pluralité de cellules de mémoire ferroélectrique et une région périphérique qui est espacée de façon latérale de la pluralité de cellules de mémoire ferroélectrique dans la région de cellule ;
la pluralité de cellules de mémoire ferroélectrique dans la région de cellule comprenant une pluralité de condensateurs, les condensateurs ferroélectriques comprenant une électrode inférieure, une couche ferroélectrique sur l'électrode inférieure, et une électrode supérieure sur la couche ferroélectrique opposée à l'électrode inférieure ;
une première couche de matériau ayant une résistance de couche comprise entre 5 et 500 Ω/□ comprenant un matériau qui est différent de celui des électrodes supérieures, sur les électrodes supérieures dans la région de cellule opposée à la couche ferroélectrique, et sur le substrat à circuit intégré dans la région périphérique, la première couche de matériau formant une pluralité de résistances dans la région périphérique ;
un film intercouche isolant sur la première couche de matériau comprenant un trou de contact ; et
une couche d'interconnexion sur le film intercouche isolant comprise dans le trou de contact.

2. Dispositif de mémoire ferroélectrique à circuit intégré selon la revendication 1, dans lequel les électrodes supérieure et inférieure comprennent un matériau sélectionné à partir d'un groupe composé d'un métal du groupe du platine, et d'un oxyde conducteur.

3. Dispositif de mémoire ferroélectrique à circuit intégré selon la revendication 2, dans lequel un métal du groupe du platine est sélectionné à partir du groupe composé de Pt, Ru, Ir, Pd et Os.

4. Dispositif de mémoire ferroélectrique à circuit intégré selon la revendication 2, dans lequel l'oxyde conducteur est sélectionné à partir du groupe composé du IrO₂, de l'oxyde de platine, de l'oxyde d'osmium, de l'oxyde d'indium, de l'oxyde d'étain d'indium (ITO), et du RuO₂.

5. Dispositif de mémoire ferroélectrique à circuit intégré selon la revendication 1, dans lequel la couche ferroélectrique comprend un matériau sélectionné à partir du groupe composé d'un oxyde ayant une structure de Pérovskite, Bi₆Ti₃O₁₂ et SrBi₂Ta₂O₉.

6. Dispositif de mémoire ferroélectrique à circuit intégré selon la revendication 5, dans lequel l'oxyde ayant une structure de Pérovskite est sélectionné à partir du groupe composé de PZT, PbTiO₂, PbLaTiO₃, BaTiO₃, BTS (BaSrTiO₃) et STO (SrTiO₃).

7. Dispositif de mémoire ferroélectrique à circuit intégré selon la revendication 1, dans lequel la première couche de matériau comprend un matériau sélectionné à partir du groupe composé de polysilicium, de siliciure de tungstène, SiN, Al₂O₃, TiSiₓN_{y}, et TaSiₓN_{y}.

8. Dispositif de mémoire ferroélectrique à circuit intégré selon la revendication 1, comprenant en outre une première couche de barrage sur la première couche de matériau, et une couche d'interconnexion sur la première couche de barrage, dans lequel la première couche de barrage empêche toute réaction entre la première couche de matériau et la couche d'interconnexion.

9. Dispositif de mémoire ferroélectrique à circuit intégré selon la revendication 8, dans lequel la première couche de barrage est sélectionnée à partir du groupe composé d'un double film de Ti/TiN, Ir, Ru, RuO₂, TiSiₓN_{y} et IrO₂.

10. Dispositif de mémoire ferroélectrique à circuit intégré selon la revendication 1, comprenant en outre une couche de barrage entre l'électrode supérieure et la première couche de matériau, qui empêche toute réaction entre l'électrode supérieure et la première couche de matériau.

11. Dispositif de mémoire ferroélectrique à circuit intégré selon la revendication 10, dans lequel la couche de barrage est sélectionnée à partir du groupe composé de Ti/TiN, Ir, Ru, RuO₂, TiSiₓN_{y} et TaSiₓN_{y}.

12. Dispositif de mémoire ferroélectrique à circuit intégré selon la revendication 8, comprenant en outre une seconde couche de barrage entre l'électrode supérieure et la première couche de matériau, qui empêche toute réaction entre l'électrode supérieure et la première couche de matériau.

13. Dispositif de mémoire ferroélectrique à circuit intégré selon la revendication 1, dans lequel la première couche de matériau facilite l'adhérence entre l'électrode supérieure et la couche d'interconnexion.

14. Dispositif de mémoire ferroélectrique à circuit intégré selon la revendication 1, dans lequel la première couche de matériau facilite l'adhérence entre l'électrode supérieure et la couche d'isolation.

15. Procédé de fabrication d'un dispositif de mémoire ferroélectrique à circuit intégré, comprenant les étapes consistant à :
définir, dans un substrat à circuit intégré, une région de cellule et une région périphérique qui est espacée de façon latérale de la pluralité de cellules de mémoire ferroélectriques dans la région de cellule ;
fabriquer une pluralité de cellules de mémoire ferroélectriques dans une région de cellule, comprenant une pluralité de condensateurs ferroélectriques, les condensateurs ferroélectriques comprenant une électrode inférieure, une couche ferroélectrique sur l'électrode inférieure, et une électrode supérieure sur la couche ferroélectrique opposée à l'électrode inférieure ;
former une première couche de matériau avec une résistance de couche comprise entre 5 et 500 Ω/□, comprenant un matériau qui est différent de celui des électrodes supérieures, sur les électrodes supérieures dans la région de cellule opposée à la couche ferroélectrique, et sur le substrat à circuit intégré dans la région périphérique, la première couche de matériau formant une pluralité de résistances dans la région périphérique ;
former une couche isolante intercouche sur la première couche de matériau, comprenant un trou de contact qui laisse apparaître la première couche de matériau ; et
former une couche d'interconnexion sur la couche. isolante intercouche, comprise dans le trou de contact.

16. Procédé selon la revendication 15, dans lequel l'étape de formation de la première couche de matériau est suivie par les étapes consistant à :
former ladite couche isolante intercouche sur la première couche de matériau, comprenant un trou de contact qui laisse apparaître l'électrode supérieure ; et
former ladite couche d'interconnexion sur la couche isolante intercouche, comprise dans le trou de contact.

17. Procédé selon la revendication 15, dans lequel les électrodes supérieure et inférieure comprennent un matériau sélectionné à partir du groupe composé d'un métal du groupe du platine, et d'un oxyde conducteur,

18. Procédé selon la revendication 17, dans lequel le métal du groupe du platine est sélectionné à partir du groupe composé de Pt, Ru, Ir, Pd et Os.

19. Procédé selon la revendication 17, dans lequel l'oxyde conducteur est sélectionné à partir du groupe composé de IrO₂, de l'oxyde de platine, de l'oxyde d'osmium, de l'oxyde d'indium, de l'oxyde d'étain d'indium (ITO), et du RuO₂.

20. Procédé selon la revendication 17, dans lequel la couche ferroélectrique comprend un matériau sélectionné à partir du groupe composé d'un oxyde ayant une structure de Pérovskite, Bi₄Ti₃O₁₂ et SrBi₂Ta₂O₉.

21. Procédé selon la revendication 20, dans lequel l'oxyde ayant une structure de Pérovskite est sélectionné à partir d'un groupe composé de PZT, PbTiO₃, PbLaTiO₃, BST (BaSrTiO₃) et STO (SrTiO₃)

22. Procédé selon la revendication 15, dans lequel la première couche de matériau est sélectionnée à partir du groupe composé de polysilicium, de siliciure de tungstène, SiN, Al₂O₃, TiSiₓN_{y}, et TaSiₓN_{y}.

23. Procédé selon la revendication 15, dans lequel l'étape de formation d'une première couche de matériau est suivie par l'étape consistant à former une première couche de barrage sur la première couche de matériau pour empêcher toute réaction de la première couche de matériau et de la couche d'interconnexion.

24. Procédé selon la revendication 23, dans lequel la première couche de barrage est sélectionnée à partir du groupe composé d'un double film de Ti/TiN, TiSiₓN_{y}, TaSiₓN_{y}, Ir, IrO₂, Ru et RuO₂.

25. Procédé selon la revendication 15, dans lequel l'étape suivante est réalisée avant l'étape de formation d'une première couche de matériau ;
former une couche de barrage sur l'électrode supérieure pour empêcher toute réaction entre l'électrode supérieure et la première couche de matériau.

26. Procédé selon la revendication 25, dans lequel une seconde couche de barrage est sélectionnée à partir du groupe composé de Ti/TiN, Ir, Ru, RuO₂, TiSiₓN_{y} et TaSiₓN_{y}.

27. Procédé selon la revendication 23, dans lequel l'étape suivante est réalisée avant l'étape de formation d'une première couche de matériau ;
former une seconde couche de barrage sur l'électrode supérieure pour empêcher toute réaction entre l'électrode supérieure et la première couche de matériau.
